(19) Europäisches Patentamt
European Patent Office
Office européen des brevets

(11) **EP 2 805 398 B1**

(12) **EUROPÄISCHE PATENTSCHRIFT**

(45) Veröffentlichungstag und Bekanntmachung des Hinweises auf die Patenterteilung:
**18.10.2017 Patentblatt 2017/42**

(21) Anmeldenummer: **12708522.3**

(22) Anmeldetag: **29.02.2012**

(51) Int Cl.:
*H02J 3/38* (2006.01)   *H02J 13/00* (2006.01)
*H02J 3/04* (2006.01)

(86) Internationale Anmeldenummer:
**PCT/EP2012/053408**

(87) Internationale Veröffentlichungsnummer:
**WO 2013/127447 (06.09.2013 Gazette 2013/36)**

(54) **ÜBERWACHUNG EINES ELEKTRISCHEN ENERGIEVERSORGUNGSNETZES**

MONITORING AN ELECTRICAL POWER SUPPLY NETWORK

SURVEILLANCE D'UN RÉSEAU D'ALIMENTATION EN ÉNERGIE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**26.11.2014 Patentblatt 2014/48**

(73) Patentinhaber: **Siemens Aktiengesellschaft 80333 München (DE)**

(72) Erfinder:
• **LITZINGER, Andreas 90765 Fürth (DE)**
• **PIEL, Stefan 45359 Essen (DE)**

(56) Entgegenhaltungen:
**WO-A1-01/82444       US-A1- 2004 021 470
US-A1- 2008 179 966**

EP 2 805 398 B1

**Beschreibung**

Die Erfindung bezieht sich auf ein Verfahren zum Überwachen eines elektrischen Energieversorgungsnetzes.

Bekanntermaßen kann im Falle einer Überlastung ein ursprünglich hinsichtlich seiner Netzfrequenz synchrones elektrisches Energieversorgungsnetz infolge eines nach Feststellung definierter elektrischer Grenzwerte automatischen Öffnens entsprechender Schaltverbindungen in einzelne elektrische, in sich nicht mehr zeitlich synchrone elektrische Inseln aufgetrennt werden. Aufgrund des unmittelbar nach der Inselbildung in den einzelnen Zonen des Energieversorgungsnetzes nicht mehr gewährleisteten Gleichgewichts zwischen elektrischer Energieerzeugung und elektrischem Energieverbrauch stellt sich in den einzelnen Inseln - bestimmt durch den Selbstregeleffekt des Energieversorgungsnetzes und den Einsatz der Primärregelung der im Energieversorgungsnetz vorhandenen Energieerzeuger - mit einer gewissen Verzögerung jeweils eine inselindividuelle bzw. ein für die jeweilige Insel charakteristische Netzfrequenz ein, die mit den innerhalb des jeweiligen Inselabschnittes verfügbaren Energieerzeugungseinheiten möglichst umgehend wieder auf den jeweiligen Frequenzsollwert von beispielsweise 50 Hz oder 60 Hz zurückgeregelt werden muss, um einen vollständigen Zusammenbruch des elektrischen Energieversorgungsnetzes bzw. eine Beschädigung der zum Energieversorgungsnetz gehörenden elektrischen Großkomponenten zu verhindern.

Aus der US 2008/179966 A1 ist in diesem Zusammenhang eine Netzverbindungseinrichtung bekannt, die aufgrund lokaler Messwerte und gegebenenfalls eines einen Fehler im Energieversorgungsnetz angebenden Fehlersignals eine Erkennung einer Inselbildung vornimmt.

Demgemäß liegt der Erfindung die Aufgabe zugrunde, ein Verfahren zum Überwachen eines elektrischen Energieversorgungsnetzes anzugeben, das schnell und zuverlässig eine mögliche Inselbildung innerhalb des Energieversorgungsnetzes anzeigen kann.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass für zumindest zwei Abschnitte oder für zumindest zwei Stellen des Energieversorgungsnetzes ein die jeweilige zeitliche Frequenzänderung der Netzfrequenz angebender zeitlicher Frequenzänderungswert bestimmt wird und auf eine mögliche Inselbildung innerhalb des Energieversorgungsnetzes geschlossen und ein die mögliche Inselbildung innerhalb des Energieversorgungsnetzes angebendes Warnsignal erzeugt wird, wenn die Differenz zwischen den Frequenzänderungswerten einen vorgegebenen Frequenzänderungsschwellenwert überschreitet.

Ein wesentlicher Vorteil des erfindungsgemäßen Verfahrens ist darin zu sehen, dass eine mögliche Inselbildung besonders schnell erkannt und angezeigt werden kann, da die zeitliche Frequenzänderung der Netzfrequenz für unterschiedliche Stellen des Energieversorgungsnetzes ausgewertet und auf ein Überschreiten eines vorgegebenen Frequenzänderungsschwellenwertes hin überwacht wird. Erfinderseitig wurde festgestellt, dass durch ein Überwachen der Frequenzänderungswerte für unterschiedliche Stellen des Energieversorgungsnetzes besonders schnell und zuverlässig eine mögliche Inselbildung erkannt werden kann.

Bei dem Energieversorgungsnetz handelt es sich vorzugsweise um ein Verteilnetz, z. B. ein Verteilnetz der Mittelspannungsebene oder ein Verteilnetz der Niederspannungsebene, oder um ein Transportnetz, z. B. ein Transportnetz der Hochspannungsebene bzw. ein Hochspannungsnetz.

Das Messen der Frequenzänderungswerte für die zumindest zwei Abschnitte bzw. für die zumindest zwei Stellen wird vorzugsweise durch ein unmittelbares Messen der Frequenzänderungswerte in diesen zumindest zwei Abschnitten bzw. an diesen zumindest zwei Stellen durchgeführt.

Bezüglich der Bildung der Frequenzänderungswerte wird es als vorteilhaft angesehen, wenn für die zumindest zwei Abschnitte oder für die zumindest zwei Stellen des Energieversorgungsnetzes die Netzfrequenzen jeweils unter Bildung eines zeitabhängigen Frequenzwerts gemessen werden und die zeitabhängigen Frequenzwerte nach der Zeit unter Bildung jeweils eines der zeitlichen Frequenzänderungswerte abgeleitet werden.

Vorzugsweise wird auf das Vorliegen einer Inselbildung innerhalb des Energieversorgungsnetzes geschlossen und ein die Inselbildung innerhalb des Energieversorgungsnetzes angebendes Inselbildungssignal erzeugt, wenn die Differenz zwischen den Frequenzwerten einen vorgegebenen Frequenzschwellenwert überschreitet.

Nach Bildung des Inselbildungssignals wird das Inselbildungssignal vorzugsweise erst dann wieder zurückgesetzt oder abgeschaltet, wenn die Differenz zwischen den Frequenzwerten einen vorgegebenen ersten Rücksetzschwellenwert unterschreitet und die Differenz zwischen den zeitlichen Frequenzänderungswerten einen vorgegebenen zweiten Rücksetzschwellenwert unterschreitet. Ein verzögertes bzw. gesteuertes Rücksetzen eines einmal gebildeten Inselbildungssignals bietet den Vorteil, dass eine vorzeitige und womöglich verfrühte Entwarnung vermieden wird.

Als vorteilhaft wird es angesehen, wenn der erste Rücksetzschwellenwert dem Frequenzschwellenwert entspricht oder kleiner als der Frequenzschwellenwert ist.

Auch wird der zweite Rücksetzschwellenwert bevorzugt dem Frequenzänderungsschwellenwert entsprechen oder kleiner als der Frequenzänderungsschwellenwert sein.

Darüber hinaus wird es als vorteilhaft angesehen, wenn ein eine mögliche Inselbildung innerhalb des Energieversorgungsnetzes angebendes Vorwarnsignal erzeugt wird, wenn die Differenz zwischen den Netzfrequenzen einen vorgegebenen Vorwarnschwellenwert überschreitet.

Zur Messung der Netzfrequenz und/oder der Frequenzänderungswerte in den zumindest zwei Abschnitten bzw. an den zumindest zwei Stellen des Energieversorgungsnetzes wird es als vorteilhaft angesehen, wenn sogenannte Zeigermessgeräte eingesetzt werden; es wird also als vorteilhaft angesehen, wenn in den zumindest zwei Abschnitten oder an den zumindest zwei Stellen des Energieversorgungsnetzes jeweils mit einem Zeigermessgerät zumindest eine Zeigermessgröße, der zur Zeigermessgröße gehörende jeweilige Frequenzwert und der jeweilige zeitliche Frequenzänderungswert ermittelt werden, die Frequenzwerte und die Frequenzänderungswerte an eine Zentraleinrichtung übertragen werden, und mit der Zentraleinrichtung die empfangenen Frequenzwerte und die empfangenen Frequenzänderungswerte ausgewertet werden und in Abhängigkeit von den empfangenen Frequenzwerten und den empfangenen Frequenzänderungswerten das Warnsignal und/oder das Inselbildungssignal erzeugt wird.

Mit den Zeigermessgeräten kann beispielsweise die Phasendifferenz zwischen den Phasen der Spannungszeiger in den zumindest zwei Abschnitten, deren Änderung (Schlupf) sowie die Änderung des Schlupfes (Beschleunigung) des Spannungszeigers ermittelt werden.

Die Erfindung bezieht sich darüber hinaus auf eine Anordnung zum Überwachen eines elektrischen Energieversorgungsnetzes. Bezüglich einer solchen Anordnung wird erfindungsgemäß vorgeschlagen, dass in zumindest zwei Abschnitten oder an zumindest zwei Stellen des Energieversorgungsnetzes jeweils zumindest eine Messeinrichtung angeordnet ist, die geeignet ist, einen die jeweilige Netzfrequenz angebenden Frequenzwert und/oder einen die jeweilige zeitliche Frequenzänderung der Netzfrequenz angebenden zeitlichen Frequenzänderungswert zu bestimmen, und eine Zentraleinrichtung vorhanden ist, die geeignet ist, auf eine mögliche Inselbildung innerhalb des Energieversorgungsnetzes zu schließen und ein die mögliche Inselbildung innerhalb des Energieversorgungsnetzes angebendes Warnsignal zu erzeugen, wenn die Differenz zwischen den Frequenzänderungswerten einen vorgegebenen Frequenzänderungsschwellenwert überschreitet.

Bezüglich der Vorteile der erfindungsgemäßen Anordnung sei auf die obigen Ausführungen im Zusammenhang mit dem erfindungsgemäßen Verfahren verwiesen, da die Vorteile der erfindungsgemäßen Anordnung denen des erfindungsgemäßen Verfahrens im Wesentlichen entsprechen.

Vorzugsweise handelt es sich bei der Zentraleinrichtung um eine von den Messeinrichtungen separate Einrichtung, die über eine Kommunikationsverbindung mit den Messeinrichtungen in Verbindung steht.

Alternativ kann die Zentraleinrichtung in einer Messeinrichtung integriert sein oder einen Bestandteil einer der Messeinrichtungen bilden.

Die Erfindung bezieht sich darüber hinaus auf eine Zentraleinrichtung für eine Anordnung, wie sie oben beschrieben worden ist. Erfindungsgemäß ist bezüglich einer solchen Zentraleinrichtung vorgesehen, dass die Zentraleinrichtung eine Recheneinrichtung aufweist, die geeignet ist, von zumindest zwei Messeinrichtungen jeweils einen die jeweilige zeitliche Frequenzänderung der Netzfrequenz angebenden zeitlichen Frequenzänderungswert zu empfangen und/oder aus Messwerten der zumindest zwei Messeinrichtungen die zeitlichen Frequenzänderungswerte zu bestimmen und ein eine mögliche Inselbildung innerhalb des Energieversorgungsnetzes angebendes Warnsignal zu erzeugen, wenn die Differenz zwischen den Frequenzänderungswerten einen vorgegebenen Frequenzänderungsschwellenwert überschreitet.

Bezüglich der Vorteile der erfindungsgemäßen Zentraleinrichtung sei auf die obigen Ausführungen im Zusammenhang mit dem erfindungsgemäßen Verfahren verwiesen, da die Vorteile der erfindungsgemäßen Zentraleinrichtung denen des erfindungsgemäßen Verfahrens im Wesentlichen entsprechen.

Die Erfindung wird nachfolgend anhand von Ausführungsbeispielen näher erläutert; dabei zeigen beispielhaft:

Figur 1    ein Ausführungsbeispiel für eine Anordnung zum Überwachen eines elektrischen Energieversorgungs-netzes mit Messeinrichtungen sowie einer mit den Messeinrichtungen verbundenen Zentraleinrichtung,

Figur 2    beispielhaft die Arbeitsweise der Zentraleinrich-tung der Anordnung gemäß Figur 1 und

Figur 3    beispielhaft eine Bildung von Rücksetzsignalen für die Anordnung gemäß Figur 1.

In den Figuren werden der Übersicht halber für identische oder vergleichbare Komponenten stets dieselben Bezugszeichen verwendet.

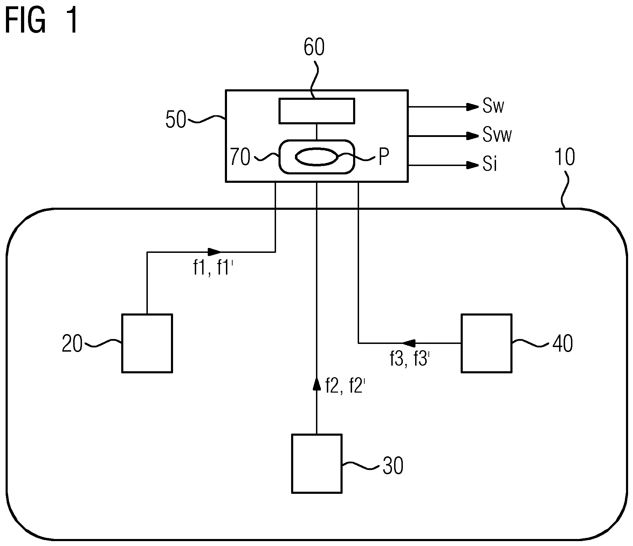

In der Figur 1 ist ein Energieversorgungsnetz nur schematisch dargestellt und mit einem Bezugszeichen 10 gekennzeichnet. Innerhalb des Energieversorgungsnetzes 10 befindet sich eine Vielzahl an Messeinrichtungen, von denen in der Figur 1 aus Gründen der Übersicht lediglich drei Messeinrichtungen dargestellt und mit den Bezugszeichen 20, 30 und 40 gekennzeichnet sind. Die drei Messeinrichtungen 20, 30 und 40 befinden sich an unterschiedlichen Stellen bzw. in unterschiedlichen Abschnitten des Energieversorgungsnetzes 10.

Mit den drei Messeinrichtungen 20, 30 und 40 steht eine Zentraleinrichtung 50 in Verbindung, die eine Recheneinrichtung 60 sowie einen Speicher 70 umfasst. In dem Speicher 70 ist ein Programm P abgespeichert, das die Arbeitsweise der Recheneinrichtung 60 bestimmt.

Bei den drei Messeinrichtungen 20, 30 und 40 kann es sich beispielsweise um Zeigermessgeräte, sogenannte PMUs (Phasor Measuring Unit), handeln. Solche Zeigermessgeräte sind üblicherweise in der Lage, Zeigergrößen (also komplexe Messwerte nach Betrag und Phase), wie beispielsweise Spannungszeigermessgrößen oder Stromzeigermessgrößen zu bestimmen.

Nachfolgend wird beispielhaft davon ausgegangen, dass die drei Messeinrichtungen 20, 30 und 40 jeweils die Netzfrequenz an der ihnen zugeordneten Stelle innerhalb des Energieversorgungsnetzes 10 messen und die entsprechenden Frequenzwerte an die Zentraleinrichtung 50 übermitteln. Die Frequenzwerte sind in der Figur 1 mit den Bezugszeichen f1, f2 und f3 gekennzeichnet.

Darüber hinaus ermitteln die drei Messeinrichtungen 20, 30 und 40 jeweils auch Frequenzänderungswerte f1', f2' und f3', die die zeitliche Frequenzänderung der Netzfrequenz an der jeweiligen Stelle im Energieversorgungsnetz 10 angeben. Die drei Messeinrichtungen 20, 30 und 40 können die zeitlichen Frequenzänderungswerte f1', f2' und f3' beispielsweise durch ein mathematisches Ableiten der zeitabhängigen Frequenzwerte f1, f2 und f3 nach der Zeit bilden, also gemäß

$$f1' = df1/dt$$

$$f2' = df2/dt$$

$$f3' = df3/dt$$

Die Recheneinrichtung 60 der Zentraleinrichtung 50 empfängt die drei Frequenzwerte f1, f2 und f3 sowie die drei Frequenzänderungswerte f1', f2' und f3' und erzeugt ausgangsseitig ein Vorwarnsignal Svw, ein Warnsignal Sw und/oder ein Inselbildungssignal Si, wenn in dem Programm P und/oder in dem Speicher 70 vorgegebene Kriterien erfüllt sind.

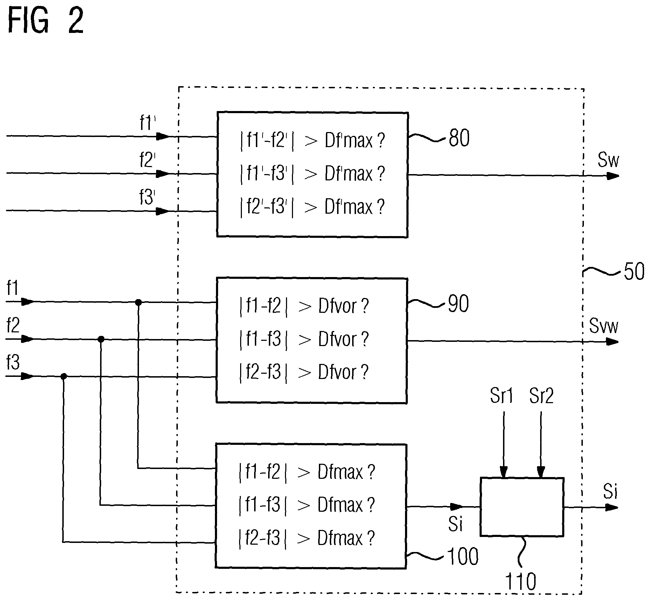

Anhand der Figur 2 soll nachfolgend ein Ausführungsbeispiel für die Arbeitsweise der Zentraleinrichtung 50 erläutert werden. Man erkennt in der Figur 2, dass die Zentraleinrichtung 50 drei Entscheidungsmodule bereitstellt bzw. abarbeitet, von denen ein erstes Entscheidungsmodul mit dem Bezugszeichen 80, ein zweites Entscheidungsmodul mit dem Bezugszeichen 90 und ein drittes Entscheidungsmodul mit dem Bezugszeichen 100 gekennzeichnet ist.

In dem ersten Entscheidungsmodul 80 prüft die Zentraleinrichtung 50, ob die Differenz zwischen den eingangsseitig anliegenden Frequenzänderungswerten f1', f2' und f3' einen vorgegebenen Frequenzänderungsschwellenwert Df'max überschreitet oder nicht.

Stellt das erste Entscheidungsmodul 80 fest, dass zumindest eine der drei Differenzen den vorgegebenen Frequenzänderungsschwellenwert Df'max überschreitet, so erzeugt sie ausgangsseitig das Warnsignal Sw beispielsweise mit einer logischen "1".

Stellt das erste Entscheidungsmodul 80 hingegen fest, dass keine der drei Differenzen den vorgegebenen Frequenzänderungsschwellenwert Df'max überschreitet, so wird ausgangsseitig ein Warnsignal Sw beispielsweise mit einer logischen "0" erzeugt.

Die Zuordnung des logischen Pegels erfolgt also beispielsweise wie folgt:

$$|f1'-f2'| > Df'max \Rightarrow Sw="1"$$

$$|f1'-f3'| > Df'max \Rightarrow Sw="1"$$

$$|f2'-f3'| > Df'max \Rightarrow Sw="1"$$

$$|f1'-f2'| \leq Df'max \text{ und } |f1'-f3'| \leq Df'max \text{ und } |f2'-f3'| \leq$$
$$Df'max \Rightarrow Sw="0"$$

Das zweite Entscheidungsmodul 90 überprüft die drei Frequenzwerte f1, f2 und f3, die von den drei Messeinrichtungen 20, 30 und 40 gemäß Figur 1 geliefert werden. Es bildet Differenzwerte zwischen den Frequenzwerten und erzeugt das Vorwarnsignal Svw beispielsweise mit einer logischen "1", wenn zumindest eine Differenz zwischen den Frequenzwerten einen vorgegebenen Vorwarnschwellenwert Dfvor überschreitet. Stellt das zweite Entscheidungsmodul 90 hingegen fest, dass keine der Differenzen zwischen den Netzfrequenzen den vorgegebenen Vorwarnschwellenwert Dfvor überschreitet, so wird ausgangsseitig ein Vorwarnsignal Svw beispielsweise mit einer logischen "0" erzeugt.

Für die Zuordnung der logischen Signalpegel gilt also beispielsweise:

$$|f1-f2| > Dfvor \Rightarrow Svw="1"$$

$$|f1-f3| > Dfvor \Rightarrow Svw="1"$$

$$|f2-f3| > Dfvor \Rightarrow Svw="1"$$

$$|f1-f2| \leq Dfvor \text{ und } |f1-f3| \leq Dfvor \text{ und } |f2-f3| \leq Dfvor \Rightarrow$$
$$Svw="0"$$

Das dritte Entscheidungsmodul 100 dient zum Bilden eines Inselbildungssignals Si, wenn die von den drei Messeinrichtungen 20, 30 und 40 gemäß Figur 1 gelieferten Frequenzwerte f1, f2 und f3 eine Inselbildung nahelegen; davon geht das dritte Entscheidungsmodul 100 aus, wenn die Differenzen zwischen den Frequenzwerten f1, f2 und f3 zu groß sind. Das Inselbildungssignal Si wird beispielsweise mit einer logischen "1" erzeugt, wenn zumindest eine Differenz zwischen den Frequenzwerten einen vorgegebenen Frequenzschwellenwert Dfmax überschreitet. Stellt das dritte Entscheidungsmodul 100 hingegen fest, dass keine der drei Differenzen den vorgegebenen Frequenzschwellenwert Dfmax überschreitet, so wird ausgangsseitig ein Inselbildungssignal Si mit einer logischen "0" erzeugt.

Für die Zuordnung der logischen Signalpegel gilt also beispielsweise:

$$|f1-f2| > Dfmax \Rightarrow Si="1"$$

$$|f1-f3| > Dfmax \Rightarrow Si="1"$$

$$|f2-f3| > Dfmax \Rightarrow Si="1"$$

$$|f1-f2| \leq Dfmax \text{ und } |f1-f3| \leq Dfmax \text{ und } |f2-f3| \leq Dfmax \Rightarrow$$
$$Si="0"$$

In der Figur 2 lässt sich erkennen, dass dem dritten Entscheidungsmodul 100 ein Signalspeicher 110 nachgeordnet ist, bei dem es sich beispielsweise um ein Flip-Flop oder dergleichen handeln kann. Die Funktion des Signalspeichers 110 besteht darin, das Inselbildungssignal Si zwischenzuspeichern. Dies soll nachfolgend im Detail näher erläutert werden:

Wird von dem dritten Entscheidungsmodul 100 das Inselbildungssignal Si mit einer logischen "1" erzeugt, so wird diese logische "1" vom Signalspeicher 110 durchgeleitet, so dass das Inselbildungssignal Si mit einer logischen "1" am Ausgang des Signalspeichers 110 ausgegeben wird.

Der logische Signalpegel "1" wird von dem Signalspeicher 110 gespeichert und ausgangsseitig auch dann weitergegeben, wenn das Inselbildungssignal Si von dem dritten Entscheidungsmodul 100 zwischenzeitlich nicht mehr erzeugt wird. Ein Zurücksetzen des vom Signalspeicher 110 ausgegebenen Inselbildungssignals Si auf eine logische "0" erfolgt nur dann, wenn sowohl ein erstes Rücksetzsignal Sr1 als auch ein zweites Rücksetzsignal Sr2 eine logische "1" aufweisen. Also erst dann, wenn das vom dritten Entscheidungsmodul 100 erzeugte Ausgangssignal eine logische "0" aufweist und gleichzeitig die beiden Rücksetzsignale Sr1 und Sr2 eine logische "1" aufweisen, kommt es zu einem Löschen des Signalpegels des Inselbildungssignals Si und einer Ausgabe des Inselbildungssignals Si mit einer logischen "0".

Das erste Rücksetzsignal kann beispielsweise mit einer logischen "1" gebildet werden, wenn die Differenz zwischen den Frequenzwerten einen vorgegebenen ersten Rücksetzschwellenwert unterschreitet.

Das zweite Rücksetzsignal Sr2 kann beispielsweise mit einer logischen "1" erzeugt werden, wenn die Differenz zwischen den zeitlichen Frequenzänderungswerten einen vorgegebenen zweiten Rücksetzschwellenwert unterschreitet.

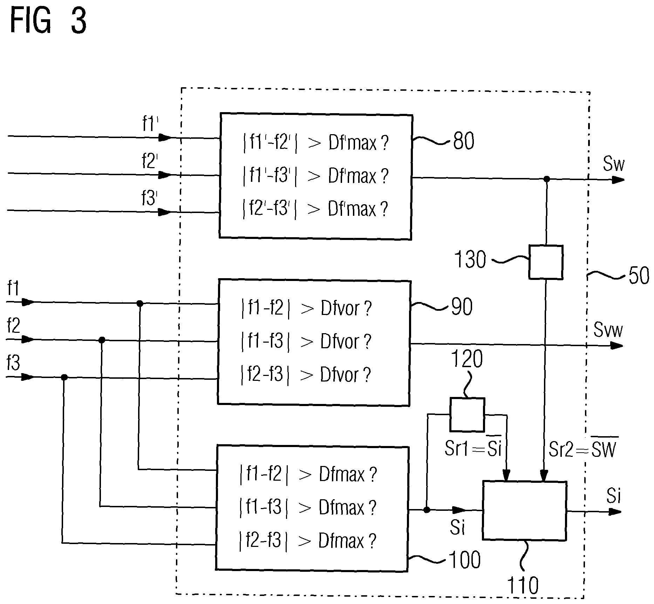

Die Figur 3 zeigt beispielhaft, wie sich die beiden Rücksetzsignale Sr1 und Sr2 in einfacher Weise bilden lassen:

Für die Bildung des ersten Rücksetzsignals Sr1 kann beispielsweise der Frequenzschwellenwert Dfmax herangezogen werden, der von dem dritten Entscheidungsmodul 100 verwendet wird. In diesem Fall kann das erste Rücksetzsignal Sr1 in einfacher Weise durch ein Invertieren des von dem dritten Entscheidungsmodul 100 ausgegebenen Inselbildungssignals Si mittels eines Inverters 120 erzeugt werden. Der Inverter 120 invertiert das Inselbildungssignal Si des dritten Entscheidungsmoduls 100 und gibt das invertierte Inselbildungssignal Si als erstes Rücksetzsignal Sr1 an den Signalspeicher 110 aus.

Bei dem zweiten Rücksetzsignals Sr2 kann beispielsweise der Frequenzänderungsschwellenwert Df'max berücksichtigt werden, den das erste Entscheidungsmodul 80 im Rahmen der Erzeugung des Warnsignals Sw heranzieht. Beispielsweise kann ein zweiter Inverter 130 das Ausgangssignal des ersten Entscheidungsmoduls 80, also das Warnsignal Sw, invertieren und das invertierte Warnsignal Sw als zweites Rücksetzsignal Sr2 in den Signalspeicher 110 einspeisen.

Im Rahmen der beschriebenen Erzeugung der beiden Rücksetzsignale Sr1 und Sr2 kommt es zu einem Rücksetzen eines zuvor auf eine logische "1" gesetzten Inselbildungssignals Si am Ausgang des Signalspeichers 110 nur dann, wenn das von dem dritten Entscheidungsmodul ausgangsseitig abgegebene Inselbildungssignal Si eine logische "0" und gleichzeitig auch das Warnsignal Sw des ersten Entscheidungsmoduls 80 eine logische "0" aufweist.

Die Erläuterungen im Zusammenhang mit den Figuren 2 und 3 sind hinsichtlich der logischen Signalpegel der Signale nur beispielhaft zu verstehen; selbstverständlich können die Signalpegel der Signale Sw, Svw, Sr1, Sr2 und Si auch anders definiert werden; in diesem Falle muss lediglich die Auswertlogik innerhalb der Zentraleinrichtung 50 entsprechend angepasst werden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Bezugszeichenliste

| 10 | Energieversorgungsnetz |
| 20 | Messeinrichtung |
| 30 | Messeinrichtung |
| 40 | Messeinrichtung |
| 50 | Zentraleinrichtung |
| 60 | Recheneinrichtung |
| 70 | Speicher |
| 80 | Entscheidungsmodul |
| 90 | Entscheidungsmodul |
| 100 | Entscheidungsmodul |
| 110 | Signalspeicher |
| 120 | Inverter |
| 130 | Inverter |

| Df'max | Frequenzänderungsschwellenwert |
| Dfmax | Frequenzschwellenwert |
| Dfvor | Vorwarnschwellenwert |
| f1 | Frequenzwert |
| f2 | Frequenzwert |
| f3 | Frequenzwert |
| f1' | Frequenzänderungswert |

| | |
|---|---|
| f2' | Frequenzänderungswert |
| f3' | Frequenzänderungswert |
| P | Programm |
| Si | Inselbildungssignal |
| Sr1 | Rücksetzsignal |
| Sr2 | Rücksetzsignal |
| Sw | Warnsignal |
| Svw | Vorwarnsignal |

**Patentansprüche**

1. Verfahren zum Überwachen eines elektrischen Energieversorgungsnetzes (10), wobei

   - für zumindest zwei Abschnitte oder für zumindest zwei Stellen des Energieversorgungsnetzes (10) ein die jeweilige zeitliche Frequenzänderung der Netzfrequenz angebender zeitlicher Frequenzänderungswert (f1', f2', f3') bestimmt wird und
   - auf eine mögliche Inselbildung innerhalb des Energieversorgungsnetzes geschlossen und ein die mögliche Inselbildung innerhalb des Energieversorgungsnetzes angebendes Warnsignal (Sw) erzeugt wird, wenn die Differenz zwischen den Frequenzänderungswerten (f1', f2', f3') einen vorgegebenen Frequenzänderungsschwellenwert (Df'max) überschreitet,

   **dadurch gekennzeichnet, dass**

   - auf das Vorliegen einer Inselbildung innerhalb des Energieversorgungsnetzes (10) geschlossen und ein die Inselbildung innerhalb des Energieversorgungsnetzes (10) angebendes Inselbildungssignal (Si) erzeugt wird, wenn die Differenz zwischen den Frequenzwerten (f1, f2, f3) einen vorgegebenen Frequenzschwellenwert (Dfmax) überschreitet und
   - nach Bildung des Inselbildungssignals (Si) das Inselbildungssignal (Si) erst dann wieder zurückgesetzt oder abgeschaltet wird, wenn

      - die Differenz zwischen den Frequenzwerten (f1, f2, f3) einen vorgegebenen ersten Rücksetzschwellenwert unterschreitet und
      - die Differenz zwischen den zeitlichen Frequenzänderungswerten (f1', f2', f3') einen vorgegebenen zweiten Rücksetzschwellenwert unterschreitet.

2. Verfahren nach Anspruch 1,
   **dadurch gekennzeichnet, dass**

   - für die zumindest zwei Abschnitte oder für die zumindest zwei Stellen des Energieversorgungsnetzes (10) die Netzfrequenzen jeweils unter Bildung eines zeitabhängigen Frequenzwerts (f1, f2, f3) gemessen werden und
   - die zeitabhängigen Frequenzwerte (f1, f2, f3) nach der Zeit unter Bildung jeweils eines der zeitlichen Frequenzänderungswerte (f1', f2', f3') abgeleitet werden.

3. Verfahren nach Anspruch 1 oder 2,
   **dadurch gekennzeichnet, dass** der erste Rücksetzschwellenwert dem Frequenzschwellenwert (Dfmax) entspricht oder kleiner als der Frequenzschwellenwert (Dfmax) ist.

4. Verfahren nach Anspruch 1 oder 2,
   **dadurch gekennzeichnet, dass** der zweite Rücksetzschwellenwert dem Frequenzänderungsschwellenwert (Df'max) entspricht oder kleiner als der Frequenzänderungsschwellenwert (Df'max) ist.

5. Verfahren nach einem der voranstehenden Ansprüche,
   **dadurch gekennzeichnet, dass** ein eine mögliche Inselbildung innerhalb des Energieversorgungsnetzes (10) angebendes Vorwarnsignal (Svw) erzeugt wird, wenn die Differenz zwischen den Frequenzwerten (f1, f2, f3) einen vorgegebenen Vorwarnschwellenwert überschreitet.

6. Verfahren nach einem der voranstehenden Ansprüche,

**dadurch gekennzeichnet, dass**

- in den zumindest zwei Abschnitten oder an den zumindest zwei Stellen des Energieversorgungsnetzes (10) jeweils mit einem Zeigermessgerät (20, 30, 40) zumindest eine Zeigermessgröße, der zur Zeigermessgröße gehörende jeweilige Frequenzwert (f1, f2, f3) und der jeweilige zeitliche Frequenzänderungswert (f1', f2', f3') ermittelt werden,
- die Frequenzwerte (f1, f2, f3) und die Frequenzänderungswerte (f1', f2', f3') an eine Zentraleinrichtung (50) übertragen werden, und
- mit der Zentraleinrichtung (50) die empfangenen Frequenzwerte (f1, f2, f3) und die empfangenen Frequenzänderungswerte (f1', f2', f3') ausgewertet werden und in Abhängigkeit von den empfangenen Frequenzwerten (f1, f2, f3) und den empfangenen Frequenzänderungswerten (f1', f2', f3') das Warnsignal (Sw) und/oder das Inselbildungssignal (Si) erzeugt wird.

7.  Anordnung zum Überwachen eines elektrischen Energieversorgungsnetzes (10), wobei

- in zumindest zwei Abschnitten oder an zumindest zwei Stellen des Energieversorgungsnetzes (10) jeweils zumindest eine Messeinrichtung (20, 30, 40) angeordnet ist, die geeignet ist, einen die jeweilige Netzfrequenz angebenden Frequenzwert (f1, f2, f3) und/oder einen die jeweilige zeitliche Frequenzänderung der Netzfrequenz angebenden zeitlichen Frequenzänderungswert (f1', f2', f3') zu bestimmen, und
- eine Zentraleinrichtung (50) vorhanden ist, die geeignet ist, auf eine mögliche Inselbildung innerhalb des Energieversorgungsnetzes (10) zu schließen und ein die mögliche Inselbildung innerhalb des Energieversorgungsnetzes (10) angebendes Warnsignal (Sw) zu erzeugen, wenn die Differenz zwischen den Frequenzänderungswerten (f1', f2', f3') einen vorgegebenen Frequenzänderungsschwellenwert (Df'max) überschreitet,

**dadurch gekennzeichnet, dass** die Zentraleinrichtung (50) dazu geeignet ist,

- auf das Vorliegen einer Inselbildung innerhalb des Energieversorgungsnetzes (10) zu schließen und ein die Inselbildung innerhalb des Energieversorgungsnetzes (10) angebendes Inselbildungssignal (Si) zu erzeugen, wenn die Differenz zwischen den Frequenzwerten (f1, f2, f3) einen vorgegebenen Frequenzschwellenwert (Dfmax) überschreitet und
- nach Bildung des Inselbildungssignals (Si) das Inselbildungssignal (Si) erst dann wieder zurückzusetzen oder abzuschalten, wenn

- die Differenz zwischen den Frequenzwerten (f1, f2, f3) einen vorgegebenen ersten Rücksetzschwellenwert unterschreitet und
- die Differenz zwischen den zeitlichen Frequenzänderungswerten (f1', f2', f3') einen vorgegebenen zweiten Rücksetzschwellenwert unterschreitet.

8.  Anordnung nach Anspruch 7,
    **dadurch gekennzeichnet, dass** die Zentraleinrichtung (50) eine von den Messeinrichtungen (20, 30, 40) separate Einrichtung ist, die über eine Kommunikationsverbindung mit den Messeinrichtungen (20, 30, 40) in Verbindung steht.

9.  Anordnung nach Anspruch 8,
    **dadurch gekennzeichnet, dass** die Zentraleinrichtung (50) in einer Messeinrichtung (20, 30, 40) integriert ist oder einen Bestandteil einer der Messeinrichtungen (20, 30, 40) bildet.

10. Zentraleinrichtung (50) für eine Anordnung nach Anspruch 7, wobei
    die Zentraleinrichtung (50) eine Recheneinrichtung (60) aufweist, die geeignet ist, von zumindest zwei Messeinrichtungen (20, 30, 40) jeweils einen die jeweilige zeitliche Frequenzänderung der Netzfrequenz angebenden zeitlichen Frequenzänderungswert (f1', f2', f3') zu empfangen und/oder aus Messwerten der zumindest zwei Messeinrichtungen (20, 30, 40) die zeitlichen Frequenzänderungswerte (f1', f2', f3') zu bestimmen und ein eine mögliche Inselbildung innerhalb des Energieversorgungsnetzes angebendes Warnsignal (Sw) zu erzeugen, wenn die Differenz zwischen den Frequenzänderungswerten (f1', f2', f3') einen vorgegebenen Frequenzänderungsschwellenwert (Df'max) überschreitet,
    **dadurch gekennzeichnet, dass** die Recheneinrichtung (60) dazu geeignet ist,

- auf das Vorliegen einer Inselbildung innerhalb des Energieversorgungsnetzes (10) zu schließen und ein die Inselbildung innerhalb des Energieversorgungsnetzes (10) angebendes Inselbildungssignal (Si) zu erzeugen, wenn die Differenz zwischen den Frequenzwerten (f1, f2, f3) einen vorgegebenen Frequenzschwellenwert (Dfmax) überschreitet und

- nach Bildung des Inselbildungssignals (Si) das Inselbildungssignal (Si) erst dann wieder zurückzusetzen oder abzuschalten, wenn

- die Differenz zwischen den Frequenzwerten (f1, f2, f3) einen vorgegebenen ersten Rücksetzschwellenwert unterschreitet und
- die Differenz zwischen den zeitlichen Frequenzänderungswerten (f1', f2', f3') einen vorgegebenen zweiten Rücksetzschwellenwert unterschreitet.

**Claims**

1. Method for monitoring an electrical power supply network (10), wherein

- a temporal frequency change value (f1', f2', f3') is determined for at least two sections or for at least two points of the power supply network (10), which value indicates the respective temporal frequency change in the network frequency, and
- a conclusion is drawn regarding possible islanding within the power supply network, and a warning signal (Sw) which indicates the possible islanding within the power supply network is generated if the difference between the frequency change values (f1', f2', f3') exceeds a predetermined frequency change threshold value (Df'max),

**characterised in that**

- a conclusion is drawn regarding the existence of islanding within the power supply network (10) and an islanding signal (Si) indicating islanding within the power supply network (10) is generated if the difference between the frequency values (f1, f2, f3) exceeds a predetermined frequency threshold value (Dfmax) and
- after forming the islanding signal (Si), the islanding signal (Si) is only reset again or switched off if

- the difference between the frequency values (f1, f2, f3) falls below a predetermined first resetting threshold value, and
- the difference between the temporal frequency change values (f1', f2', f3') falls below a predetermined second resetting threshold value.

2. Method according to claim 1,
**characterised in that**

- the network frequencies are each measured for the at least two sections or for the at least two points of the power supply network (10) by forming a time-dependent frequency value (f1, f2, f3), and
- the time-dependent frequency values (f1, f2, f3) are derived with respect to time by forming one of the temporal frequency change values (f1', f2', f3') respectively.

3. Method according to claim 1 or 2,
**characterised in that**
the first resetting threshold value matches the frequency threshold value (Dfmax) or is less than the frequency threshold value (Dfmax).

4. Method according to claim 1 or 2,
**characterised in that**
the second resetting threshold value matches the frequency change threshold value (Df'max) or is less than the frequency change threshold value (Df'max).

5. Method according to one of the preceding claims,
**characterised in that**
a pre-warning signal (Svw) indicating possible islanding within the power supply network (10) is generated if the difference between the frequency values (f1, f2, f3) exceeds a predetermined pre-warning threshold value.

6. Method according to one of the preceding claims,

**characterised in that**

- at least one pointer measured value, the respective frequency value (f1, f2, f3) pertaining to the pointer measured value and the respective temporal frequency change values (f1', f2', f3') are determined in each case by a pointer-type measuring instrument (20, 30, 40) in the at least two sections or at the at least two points of the power supply network (10),
- the frequency values (f1, f2, f3) and the frequency change values (f1', f2', f3') are transferred to a central device (50), and
- the received frequency values (f1, f2, f3) and the received frequency change values (f1', f2', f3') are evaluated by the central device (50) and the warning signal (Sw) and/or the islanding signal (Si) is/are generated as a function of the received frequency values (f1, f2, f3) and the received frequency change values (f1', f2', f3').

7. Arrangement for monitoring an electrical power supply network (10), wherein

- arranged in at least two sections or at at least two points of the power supply network (10) is at least one measuring instrument (20, 30, 40) respectively which is capable of determining a frequency value (f1, f2, f3) indicating the respective network frequency and/or a temporal frequency change value (f1', f2', f3') indicating the respective temporal frequency change in the network frequency, and
- there is a central device (50) which is capable of drawing a conclusion regarding possible islanding within the power supply network (10) and of generating a warning signal (Sw) indicating the possible islanding within the power supply network (10) if the difference between the frequency change values (f1', f2', f3') exceeds a predetermined frequency change threshold value (Df'max),

**characterised in that**
the central device (50) is capable of

- drawing a conclusion regarding the existence of islanding within the power supply network (10) and generating an islanding signal (Si) indicating islanding within the power supply network (10) if the difference between the frequency values (f1, f2, f3) exceeds a predetermined frequency threshold value (Dfmax) and,
- after forming the islanding signal (Si), only resetting or switching off the islanding signal (Si) again if

- the difference between the frequency values (f1, f2, f3) falls below a predetermined first resetting threshold value, and
- the difference between the temporal frequency change values (f1', f2', f3') falls below a predetermined second resetting threshold value.

8. Arrangement according to claim 7,
**characterised in that**
the central device (50) is a device separate from the measuring instruments (20, 30, 40) and is connected by a communications link to the measuring instruments (20, 30, 40).

9. Arrangement according to claim 8,
**characterised in that**
the central device (50) is integrated in a measuring instrument (20, 30, 40) or forms part of one of the measuring instruments (20, 30, 40).

10. Central device (50) for an arrangement according to claim 7, wherein
the central device (50) has a computing device (60) which is capable of receiving from at least two measuring instruments (20, 30, 40) one temporal frequency change value (f1', f2', f3') respectively, indicating the respective temporal frequency change in the network frequency, and/or of determining the temporal frequency change values (f1', f2', f3') from measured values of the at least two measuring instruments (20, 30, 40) and of generating a warning signal (Sw) indicating possible islanding within the power supply network if the difference between the frequency change values (f1', f2', f3') exceeds a predetermined frequency change threshold value (Df'max),
**characterised in that**
the computing device (60) is capable of

- drawing a conclusion regarding the existence of islanding within the power supply network (10) and generating an islanding signal (Si) indicating islanding within the power supply network (10) if the difference between the frequency values (f1, f2, f3) exceeds a predetermined frequency threshold value (Dfmax) and,
- after forming the islanding signal (Si), only resetting or switching off the islanding signal (Si) again if

- the difference between the frequency values (f1, f2, f3) falls below a predetermined first resetting threshold value, and
- the difference between the temporal frequency change values (f1', f2', f3') falls below a predetermined second resetting threshold value.

**Revendications**

1. Procédé de contrôle d'un réseau (10) d'alimentation en énergie électrique, dans lequel

- on détermine, pour au moins deux tronçons ou pour au moins deux points du réseau (10) d'alimentation en énergie, une valeur (f1', f2', f3') de variation de la fréquence en fonction du temps, indiquant la variation de la fréquence du réseau en fonction du temps et
- on décide d'un effet d'îlot éventuel dans le réseau d'alimentation en énergie et on produit un signal (Sw) d'avertissement indiquant l'effet d'îlot éventuel dans le réseau d'alimentation en énergie, si la différence entre les valeurs (f1', f2', f3') de variation de la fréquence dépassent une valeur (Df'max) de seuil de variation de la fréquence donnée à l'avance,

**caractérisé en ce que**

- on décide de la présence d'un effet d'îlot dans le réseau (10) d'alimentation en énergie et on produit un signal (Si) d'effet d'îlot indiquant l'effet d'îlot dans le réseau (10) d'alimentation en énergie, si la différence entre les valeurs (f1, f2, f3) de la fréquence dépassent une valeur (Dfmax) de seuil de la fréquence donnée à l'avance et
- après avoir formé le signal (Si) d'effet d'îlot, on n'écarte ou on n'interrompt le signal (Si) d'effet d'îlot que si à nouveau
- la différence entre les valeurs (f1, f2, f3) de la fréquence est inférieure à une première valeur de seuil de mise à l'écart donnée à l'avance et
- la différence entre les valeurs (f1', f2', f3') de variation de la fréquence en fonction du temps est inférieure à une deuxième valeur de seuil de mise à l'écart donnée à l'avance.

2. Procédé suivant la revendication 1,
**caractérisé en ce que**

- on mesure, pour les au moins deux tronçons ou pour les au moins deux points du réseau (10) d'alimentation en énergie, les fréquences du réseau, en formant respectivement une valeur (f1, f2, f3) de la fréquence en fonction du temps et
- on déduit des valeurs (f1, f2, f3) de la fréquence en fonction du temps, en formant respectivement l'une des valeurs (f1', f2', f3') de variation de la fréquence en fonction du temps.

3. Procédé suivant la revendication 1 ou 2,
**caractérisé en ce que**
la première valeur de seuil de mise à l'écart correspond à la valeur (Dfmax) de seuil de la fréquence ou est plus petite que la valeur (Dfmax) de seuil de la fréquence.

4. Procédé suivant la revendication 1 ou 2,
**caractérisé en ce que**
la deuxième valeur de seuil de mise à l'écart correspond à la valeur (Df'max) de seuil de variation de la fréquence ou est plus petite que la valeur (Df'max) de seuil de variation de la fréquence.

5. Procédé suivant l'une des revendications précédentes,
**caractérisé en ce que**
l'on produit un signal (Svw) de préavertissement indiquant un effet d'îlot éventuel dans le réseau (10) d'alimentation en énergie, si la différence entre les valeurs (f1, f2, f3) de la fréquence dépassent une valeur de seuil de préavertissement donnée à l'avance.

**6.** Procédé suivant l'une des revendications précédentes,
**caractérisé en ce que**

- on détermine, dans les au moins deux tronçons ou en les au moins deux points du réseau (10) d'alimentation en énergie, respectivement par un appareil (20, 30, 40) de mesure de vecteur, au moins une grandeur de mesure vectorielle, la valeur (f1, f2, f3) de la fréquence respective appartenant à la grandeur de mesure vectorielle et la valeur (f1', f2', f3') de variation de la fréquence en fonction du temps respective,
- on transmet les valeurs (f1, f2, f3) de la fréquence et les valeurs (f1', f2', f3') de variation de la fréquence à un dispositif (50) central et
- par le dispositif (50) central, on exploite les valeurs (f1, f2, f3) de la fréquence reçues et les valeurs (f1', f2', f3') de variation de la fréquence reçues et, en fonction des valeurs (f1, f2, f3) de la fréquence reçues et des valeurs (f1', f2', f3') de variation de la fréquence reçues, on produit le signal (Sw) d'avertissement et/ou le signal (Si) d'effet d'îlot.

**7.** Agencement de contrôle d'un réseau (10) d'alimentation en énergie électrique, dans lequel

- dans au moins deux tronçons ou en au moins deux points du réseau (10) d'alimentation en énergie, est monté respectivement au moins un dispositif (20, 30, 40) de mesure propre à déterminer une valeur (f1, f2, f3) de la fréquence indiquant la fréquence du réseau et/ou une valeur (f1', f2', f3') de variation de la fréquence en fonction du temps, indiquant la variation de la fréquence du réseau en fonction du temps et
- il y a un dispositif (50) central propre à décider d'un effet d'îlot éventuel dans le réseau (10) d'alimentation en énergie et à produire un signal (Sw) d'avertissement indiquant l'effet d'îlot éventuel dans le réseau (10) d'alimentation en énergie, si la différence entre les valeurs (f1', f2', f3') de variation de la fréquence dépasse une valeur (Df'max) de seuil de variation de la fréquence donnée à l'avance,

**caractérisé en ce que**
le dispositif (50) central est propre

- à décider de la présence d'un effet d'îlot dans le réseau (10) d'alimentation en énergie et à produire un signal (Si) d'effet d'îlot indiquant l'effet d'îlot dans le réseau (10) d'alimentation en énergie, si la différence entre les valeurs (f1, f2, f3) de la fréquence dépasse une valeur (Dfmax) de seuil de la fréquence donnée à l'avance et
- après la formation du signal (Si) d'effet d'îlot, à n'écarter à nouveau ou à n'interrompre le signal (Si) d'effet d'îlot, que si
- la différence entre les valeurs (f1, f2, f3) de la fréquence est inférieure à une première valeur de seuil de mise à l'écart donnée à l'avance et
- la différence entre les valeurs (f1', f2', f3') de variation de la fréquence en fonction du temps est inférieure à une deuxième valeur de seuil de mise à l'écart donnée à l'avance.

**8.** Agencement suivant la revendication 7,
**caractérisé en ce que**
le dispositif (50) central est un dispositif distinct des dispositifs (20, 30, 40) de mesure et est en liaison, par une liaison de communication, avec les dispositifs (20, 30, 40) de mesure.

**9.** Agencement suivant la revendication 8,
**caractérisé en ce que**
le dispositif (50) central est intégré dans un dispositif (20, 30, 40) de mesure ou est une partie constituante de l'un des dispositifs (20, 30, 40) de mesure.

**10.** Dispositif (50) central pour un agencement suivant la revendication 7, dans lequel
le dispositif (50) central a un dispositif (60) informatique, propre à recevoir d'au moins deux dispositifs (20, 30, 40) de mesure respectivement une valeur (f1', f2', f3') de variation de la fréquence en fonction du temps, indiquant la variation de la fréquence du réseau en fonction du temps et/ou à déterminer, à partir de valeurs de mesure des au moins deux dispositifs (20, 30, 40) de mesure les valeurs (f1', f2', f3') de variation de la fréquence en fonction du temps, et à produire un signal (Sw) d'avertissement indiquant un effet d'îlot éventuel dans le réseau d'alimentation en énergie, si la différence entre les valeurs (f1', f2', f3') de variation de la fréquence dépasse une valeur (Df'max) de seuil de variation de la fréquence donnée à l'avance,
**caractérisé en ce que**
le dispositif (60) informatique est propre

- à décider de la présence d'un effet d'îlot dans le réseau (10) d'alimentation en énergie et à produire un signal (Si) d'effet d'îlot indiquant l'effet d'îlot dans le réseau (10) d'alimentation en énergie, si la différence entre les valeurs (f1, f2, f3) de la fréquence dépasse une valeur (Dfmax) de seuil de la fréquence donnée à l'avance et
- après formation du signal (Si) d'effet d'îlot, à n'écarter à nouveau ou à n'interrompre le signal (Si) d'effet d'îlot, seulement lorsque
- la différence entre les valeurs (f1, f2, f3) de la fréquence est inférieure à une première valeur de seuil de mise à l'écart donnée à l'avance et
- la différence entre les valeurs (f1', f2', f3') de variation de la fréquence en fonction du temps est inférieure à une deuxième valeur de seuil de mise à l'écart donnée à l'avance.

FIG 1

FIG 2

$|f1'-f2'| > Df'max\ ?$

$|f1'-f3'| > Df'max\ ?$

$|f2'-f3'| > Df'max\ ?$

$\sim\!80$

$|f1-f2| > Dfvor\ ?$

$|f1-f3| > Dfvor\ ?$

$|f2-f3| > Dfvor\ ?$

$\sim\!90$

$|f1-f2| > Dfmax\ ?$

$|f1-f3| > Dfmax\ ?$

$|f2-f3| > Dfmax\ ?$

$\sim\!100$

$f1'$

$f2'$

$f3'$

$f1$

$f2$

$f3$

Sw

$\sim\!50$

Svw

Sr1    Sr2

Si

Si

110

15

## FIG 3

| | |
|---|---|
| f1' → | $|f1'-f2'| > Df'max\,?$ |
| f2' → | $|f1'-f3'| > Df'max\,?$ |
| f3' → | $|f2'-f3'| > Df'max\,?$ |

~80

Sw →

130 ~ ☐

~50

| | |
|---|---|
| f1 → | $|f1-f2| > Dfvor\,?$ |
| f2 → | $|f1-f3| > Dfvor\,?$ |
| f3 → | $|f2-f3| > Dfvor\,?$ |

~90

Svw →

120

$Sr1 = \overline{Si}$

$Sr2 = \overline{SW}$

| | |
|---|---|
| | $|f1-f2| > Dfmax\,?$ |
| | $|f1-f3| > Dfmax\,?$ |
| | $|f2-f3| > Dfmax\,?$ |

Si

Si →

~100

110

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20080179966 A1